Europäisches Patentamt

European Patent Office

Office européen des brevets

(19)

(11) Publication number: **0 443 507 A2**

# EUROPEAN PATENT APPLICATION

(21) Application number: 91102321.6

(22) Date of filing: 19.02.91

(51) Int. Cl.⁵: **H03F 1/02**

(30) Priority: **22.02.90 IT 1944490**

(43) Date of publication of application:
**28.08.91 Bulletin 91/35**

(84) Designated Contracting States:
**DE FR GB SE**

(71) Applicant: **SGS-THOMSON MICROELECTRONICS s.r.l.**
**Via C. Olivetti, 2**
**I-20041 Agrate Brianza Milano(IT)**

(72) Inventor: **Botti, Edoardo**
**Via Battù, 16/D**
**I-27029 Vigevano, Pavia(IT)**
Inventor: **Brasca, Guido**
**Via Wagner, 69**
**I-21100 Varese(IT)**

(74) Representative: **Modiano, Guido et al**
**MODIANO, JOSIF, PISANTY & STAUB**
**Modiano & Associati Via Meravigli, 16**
**I-20123 Milano(IT)**

(54) **High-efficiency audio amplifier for use in high fidelity.**

(57) A high-efficiency audio amplifier for use in high fidelity which includes a class-AB amplifier (1), which receives an audio input signal ($V_s$) and has a pair of final devices (3), and a power supply stage (5) for the final devices (3), which is suitable for generating a power supply voltage which can vary as a function of the audio input signal ($V_s$), the power supply stage (5) including a single class-D amplifier (6) which generates a first power supply voltage which is pro-portional to the input signal and a power supply (9) which generates a low voltage which is added to, and subtracted from, the first power supply voltage in order to maintain, across the final devices (3), a low voltage which is constant in a first embodiment and can drop to the minimum value required to keep the final devices (3) out of their saturation range in a second embodiment.

Fig. 1

The present invention relates to a high-efficiency audio amplifier for use in high fidelity.

In particular, the invention relates to an audio power amplifier which has a considerable increase in efficiency, with respect to the values which can be obtained with conventional class-AB stages, without in any way penalizing performance from the point of view of introduced harmonic distortion.

The need for high efficiency arises from the fact that monolithic circuits currently do not allow power dissipations higher than approximately 25 W; this in practice entails the impossibility of manufacturing class-AB amplifiers suitable for delivering high output power.

As is known, there are various solutions suitable for improving the efficiency of audio power amplifiers.

A known solution consists in using class-D amplifiers (see for example the article "Digital Amplifiers for Analog Power", J.A. Dutra, IEEE Transactions on Consumer Electronics, Vol. CE-24, No. 3, August 1978), characterized by the use of active power devices as switches, saturating them and switching them off alternatively with a high switching speed. The driving signal is, in this case, a two-level signal, in which the information to be amplified (the actual audio signal) is encoded by means of a particular modulation system; the analog signal required for driving the speaker is reobtained by means of an appropriate filtering downstream of the final stage. The efficiency of such a system reaches very high levels (theoretically 100%), but the distortion introduced in the signal is not compatible with a high sound reproduction quality (unless the level of complexity of the system is increased unacceptably by resorting to extremely high switching frequencies).

Another known solution consists in using class-G amplifiers (see for example the article "Average Efficiency of Class-G Power Amplifiers", F.H. Raab, IEEE Transactions on Consumer Electronics, Vol. CE-32, No. 2, May 1986), which comprise a final class-AB stage the power supply whereof is switched between two voltage levels ($\pm\alpha V_{CC}$ and $\pm V_{CC}$, with $\alpha<1$) according to the amplitude of the output signal (and therefore according to the power supplied to the load). Although it does not have distortion problems, this configuration entails a modest increase in efficiency with respect to class AB.

A further known solution (described for example in the article by H. Nakagaki, N. Amada and S. Inoue, "A High-Efficiency Audio Power Amplifier", J. Audio Eng. Soc., Vol. 31, No. 6, June 1983) consists in supplying the final stage, which is again executed in class AB, with a variable voltage -- obtained from a switching power supply -- which follows the behavior of the signal so as to keep the active power elements at a low-value constant voltage during their respective conduction phase; this leads to an appreciable decrease in dissipation and to a consequent increase in efficiency. Supply voltage control is implemented separately on the two half-waves (the positive one and the negative one) of the input signal, by comparing each supply voltage with the input signal (which is shifted appropriately) and by correspondingly switching a switch which is interposed by means of a low-pass filter between the switching power supply and the power supply terminal of the respective final device, so as to allow or prevent the flow of current from the switching power supply with a frequency which is correlated to the frequency of the amplifier during the period of operation of the respective final device; this increases circuital complexity and also requires the use of two LC filters, which are necessarily external to the monolithic chip.

Given this situation, the aim of the present invention is to provide a high-efficiency audio amplifier for use in high fidelity which can solve the disadvantages of the prior art.

Within the scope of this aim, a particular object of the present invention is to provide an audio amplifier which has high efficiency and low distortion levels.

An important object of the present invention is to provide an audio amplifier which, by using the principle of supplying the final devices with a variable low-value voltage, as described in the above mentioned article by Nakagaki et al., nonetheless has a reduced circuital complexity, and in particular reduces the number of external components, such as the LC filter, which cannot be integrated with the rest of the audio amplifier.

Another object of the present invention is to provide an audio amplifier of the indicated type which, in the case of an inductive load, allows to achieve even better performance in terms of dissipated power with respect to the circuit by Nakagaki et al.

Not least object of the present invention is to provide an audio amplifier which is highly reliable and which does not require, for its manufacture, devices or procedures which differ from those commonly in use in the electronics industry.

This aim, these objects and others which will become apparent hereinafter are achieved by a high-efficiency audio amplifier for use in high fidelity, as defined in the accompanying claims.

In practice, the invention consists in connecting the output of a class-D amplifier, which receives the input audio signal, to a low-voltage power supply which supplies only the final stage of the class-AB amplifier, so that the power supply of said final stage is uncoupled from the high-voltage power supply which is instead provided to the class-D amplifier and to the signal part of the class-AB amplifier.

The characteristics and advantages of the invention will become apparent from the description of two preferred embodiments, illustrated only by way of non-limitative example in the accompanying drawings, wherein:

figure 1 is a schematic circuit diagram of a first embodiment of the audio amplifier according to the invention;

figure 2 is a schematic circuit diagram of a second embodiment of the audio amplifier according to the invention;

figures 3 and 3a plot the behavior of some voltages drawn from the circuit of figure 1 with the amplifier of the final device power supply stage having a gain with a first value;

figures 4 and 4a plot the behavior of some voltages drawn from the circuit of figure 1 with the amplifier of the final device power supply stage having a second gain value; and

figures 5, 6 and 7 are graphs related to the dissipated power and to the efficiency of the audio amplifier according to the invention.

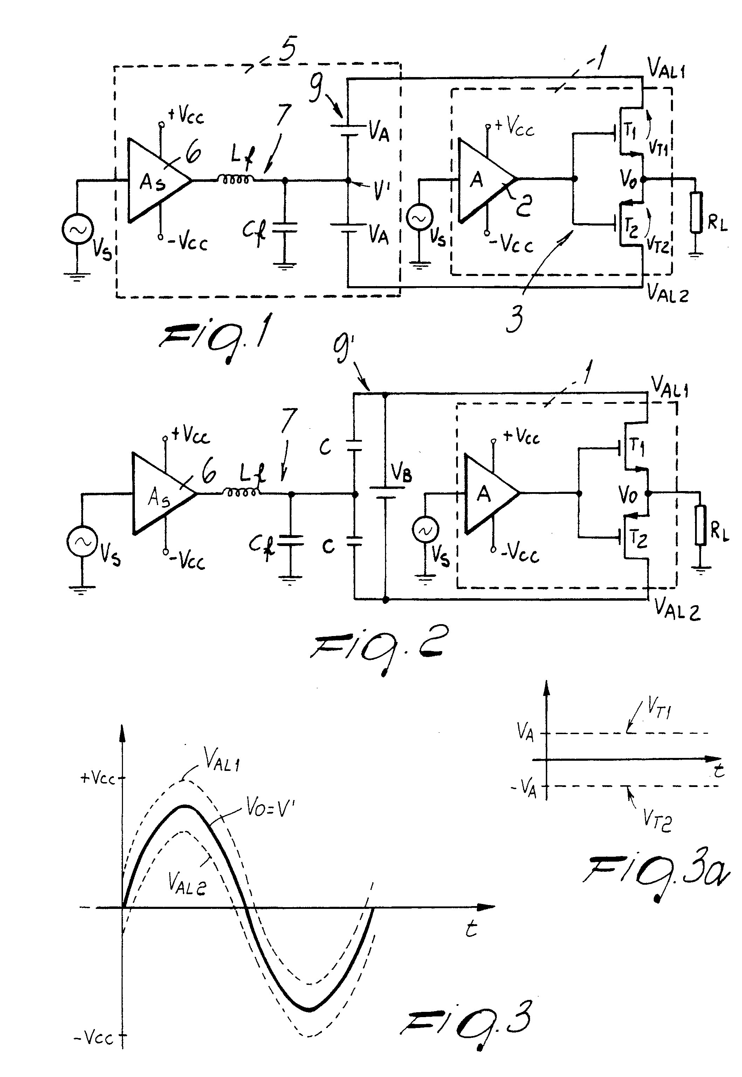

With reference to figure 1, a first embodiment of the audio amplifier comprises a final type-AB amplifier 1, which includes an amplifier stage 2 having a gain A, which receives in input the audio signal $V_s$ and is energised by two high-voltage power supplies $+V_{cc}$ and $-V_{cc}$, and a final stage 3, which is constituted by two transistors $T_1$ and $T_2$, of the MOS type in this instance, with opposite conductivity, which receive, at their control terminal, the output signal of the stage 2 and are connected in series between two power supply lines set at the voltages $V_{AL1}$ and $V_{AL2}$ generated according to the invention. The intermediate point between $T_1$ and $T_2$ is connected to the load impedance $R_L$, which is of the resistive and/or reactive type and has an output voltage $V_o$ with respect to the ground.

Similarly to the solution described in the above mentioned article by Nakagaki et al., the final devices are kept at a low voltage so as to have low dissipation. For this purpose, according to the invention, there is a single power supply stage 5 which is suitable for generating two power supply voltages which are correlated to the behavior of the input signal and specifically are the result respectively of the sum and the subtraction of two components, one of which is directly proportional to the input signal, the other one constituting a low-value voltage, in particular a constant one.

In detail, the power supply stage 5 comprises a class-D amplifier 6 (of the switching type), which has a gain $A_s$ and receives in input the audio signal to be amplified $V_s$, like the stage 2, and is energised at a high voltage at $+V_{cc}$ and $-V_{cc}$. The output of the class-D amplifier 6 is connected to a low-pass filter 7 which is formed by an inductor $L_f$ and by a capacitor $C_f$ which is in turn connected to the intermediate point of a dual power supply 9, schematically indicated by a pair of constant-voltage sources $V_A$ which add and respectively subtract the voltage $V_A$ from the output signal $V'$ of the filter 7.

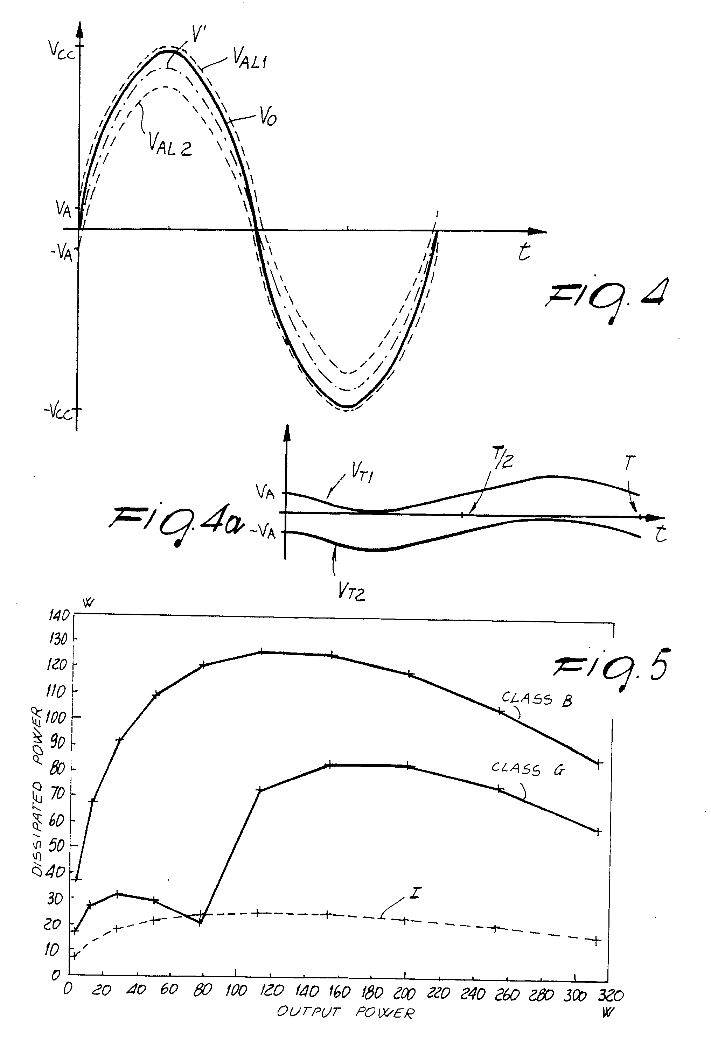

The operation of the circuit of figure 1 is now described with reference to figures 3, 3a and 4, 4a, which plot the behavior of the supply voltages $V_{AL1}$ and $V_{AL2}$ of the final stage and of the output voltage $V_o$ with the class-D amplifier having a gain by virtue of which there is, at the output of said amplifier, a low-frequency signal which has either the same amplitude as the output signal $V_o$ (figures 3 and 3a) or a slightly lower amplitude (figures 4 and 4a).

In the circuit according to the invention, in the absence of an input signal ($V_s = V_o = 0$), the voltage across the output devices is kept at a constant level (equal to $+V_A$ and $-V_A$, respectively for $T_1$ and $T_2$) which is much lower than the supply voltage $V_{cc}$ of the system.

For $V_s \neq 0$, the central point of the dual power supply 9 follows the time behaviour of the input signal (and of the output signal) so as to maintain a limited voltage value on the final power devices.

In particular, if the gain of the class-D amplifier 6 is set so as to obtain $V' = V_o$ (figure 3), a constant voltage $V_{T1}$, $V_{T2}$ equal in absolute value to $V_A$ is obtained on the final devices (e.g., if $V_{cc}$ is set equal to 50 V, $V_A$ can be chosen equal to 10 V, see figure 3a).

Alternatively, the gain of the class-D amplifier 6 can be chosen, as mentioned, so that its output has a maximum amplitude slightly lower than $V_o$. In this case, the voltage across the final devices $T_1$ and $T_2$ is variable. In particular, the amplification values $A_s$ and $V_A$ can be chosen so that the voltage across the final devices reduces practically to zero at the peak value of the maximum output signal, which is assumed to be sinusoidal (figures 4 and 4a). This solution allows to increase the total dynamic range and produces a further improvement in overall efficiency.

Figure 2 illustrates a second embodiment, in which the dual power supply 9 is replaced with a simple power supply 9'. In this case, the output of the filter 7 is connected to the common point of a pair of identical capacitors C which are connected in series and are connected, with their other terminals, to the final devices, between said other terminals a constant voltage being maintained by means of a source of a voltage $V_B$ which is double in value with respect to $V_A$ (e.g., 20 V). This solution operates exactly like the one described above with reference to figures 3, 3a, 4, 4a, but with respect thereto it has the advantage of reducing the complexity of the power supply transformer of the power supply 9' (not illustrated).

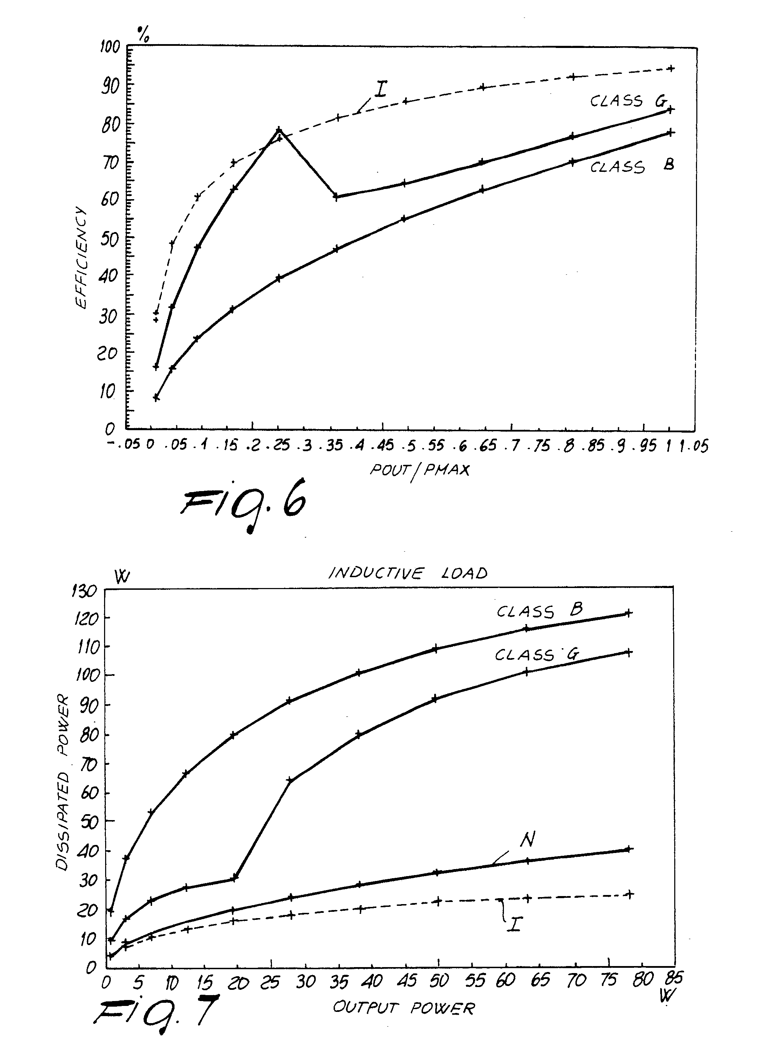

Figures 5 and 6 show the power and efficiency curves of the amplifier according to the invention, compared with the corresponding curves related to classes B and G. Said curves are obtained by assuming a $V_{CE}(sat) = 0$ and power supplies $+V_{cc}$ and $-V_{cc}$ of ±50 V on a load of 4Ω. As can be seen, the curve related to the amplifier according to the invention, indicated by I, allows to obtain a considerable improvement. In particular, maximum theoretical efficiency is close to 95%, and dissipation is kept within quite acceptable levels for a monolithic circuit even at the very high output power values plotted in said figures.

Figure 7 illustrates the curve related to the power dissipated as a function of the output power in the case of a reactive load (and specifically an inductive load). The curves of figure 7 (in which the curve related to the invention has again been indicated by I, whereas the curve related to the solution described in the article by Nakagaki et al. has been indicated by N) have been calculated assuming a shift $\Phi$ between output voltage and current which is equal to $60°$ and with the real part of the load impedance $R_L = 4$ Ω, with a power supply $\pm V_{cc} = \pm 50$ V.

As can be seen from the above description, the invention achieves the intended aim and objects. An audio amplifier for use in high fidelity has in fact been provided which can be integrated monolithically and in which it is possible to obtain high efficiency and low distortion levels with control of the supply voltage on the power supply devices by means of a single switching power supply with only two external components for the low-pass LC filter. The amplifier according to the invention therefore requires a smaller number of non-integratable external components, and furthermore allows a considerable simplification with respect to the circuitry required to implement the system described in the above mentioned article by Nakagaki et al.

The amplifier according to the invention furthermore allows to obtain a lower power dissipation even with respect to the known circuit described in said article in the case of a reactive load, as explained above.

The invention is furthermore circuitally simple and reliable.

On the subject, the fact should be noted that the high-efficiency class-D amplifier does not pose particular distortion problems, since it performs the function of controlling the power supply voltage and is not interposed in the useful audio signal amplification line, and can therefore have a structure with a low level of circuital complexity.

The invention thus conceived is susceptible to numerous modifications and variations, all of which are within the scope of the inventive concept. In particular, the fact is stressed that the low voltage which is added to the output of the class-D amplifier can be obtained not only with the dual power supply illustrated in figure 1 and the single power supply of figure 2 but also with other types of low-voltage power supplies, even ones with a non-constant voltage, which generate across the final devices voltages which have the minimum value required to keep said final devices out of their saturation range and thus reduce their dissipation.

The fact is furthermore stressed that the final devices may be constituted by either MOS transistors, as illustrated, or by bipolar transistors.

All the details may furthermore be replaced with other technically equivalent ones.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. High-efficiency audio amplifier for use in high fidelity, comprising a class-AB amplifier (1) which receives an audio input signal ($V_s$) and has a pair of final devices (3), and a power supply stage (5) for said final devices (3) which is suitable for generating a power supply voltage which varies as a function of the audio input signal ($V_s$),characterized in that said power supply stage (5) comprises means ($6,L_f,C_f$) for generating a first power supply voltage which is proportional to said audio input signal ($V_s$), means (9,9') suitable for generating a second low-value power supply voltage and adder means suitable for adding said first and second voltages for the power supply of said pair of final devices (3).

2. Amplifier according to claim 1, characterized in that it comprises a single power supply stage (5) for the power supply of said pair of final devices (3).

3. Amplifier according to the preceding claims, characterized in that said means ($6,C_f,L_f$) suitable for generating a first power supply voltage comprise a switching amplifier (6).

4. Amplifier according to one or more of the preceding claims, characterized in that said switching amplifier (6) has a gain equal to said class-AB amplifier (1).

5. Amplifier according to one or more of claims 1-3, characterized in that said audio amplifier has a lower gain than said class-AB amplifier (1).

6. Amplifier according to one or more of the preceding claims, characterized in that said means (9,9') suitable for generating a second power supply voltage comprise a dual power supply (9) which has an intermediate terminal connected to the output of said switching amplifier (6), by means of a filter circuit ($L_f$, $C_f$), and a pair of output terminals connected to respective power supply terminals of said pair of final devices (3).

7. Amplifier according to one or more of claims 1 to 5, characterized in that said means (9,9') suitable for generating a second power supply voltage comprise a single power supply (9') which is connected in parallel to a pair of capacitors (C) which are respectively connected in series and define a common terminal which is connected to the output of said switching amplifier (6) by means of a filter circuit ($L_f$,$C_f$), the opposite terminals of said pair of capacitors being connected to respective power supply terminals of said pair of final devices (3).

8. Amplifier according to one or more of the preceding claims, characterized in that said means (9,9') suitable for generating a second power supply voltage are constituted by constant-voltage sources ($V_A$,$V_B$).

9. Amplifier according to one or more of the preceding claims, characterized in that said means (6,$L_f$,$C_f$) suitable for generating said first power supply voltage and said means (9,9') for generating said second power supply voltage are configured so that the voltage across said final devices (3) is constant.

10. Amplifier according to one or more of claims 1-8, characterized in that said means (6,$L_f$,$C_f$) suitable for generating said first power supply voltage and said means (9,9') for generating said second power supply voltage are configured so that the voltage across said pair of final devices (3), at the peak value of the output signal, is at least the minimum voltage required to keep said pair of final devices (3) out of their saturation range.

Fig.1

Fig.2

Fig.3a

Fig.3

*Fig. 4*

*Fig. 4a*

*Fig. 5*

7

Fig. 6

Fig. 7